# EUROPÄISCHE PATENTSCHRIFT

(11) **EP 1 178 323 B1**
(45) Veröffentlichungstag und Bekanntmachung des Hinweises auf die Patenterteilung: **03.12.2008**
(21) Anmeldenummer: 01117224.4
(22) Anmeldetag: 16.07.2001
(51) Int. Cl.: G01R 31/3185

(54) **Verfahren zum Testen einer integrierten Schaltung**
Method for testing an integrated circuit
Procédé de test d'un circuit intégré

(30) Priorität: 03.08.2000 DE 10037794
(43) Veröffentlichungstag der Anmeldung: 06.02.2002
(73) Patentinhaber: Infineon Technologies AG, 81669 München (DE)
(72) Erfinder: Zettler, Thomas, Dr., 85635 Höhenkirchen-Siegersbrunn (DE)
(74) Vertreter: Jannig, Peter

(56) Entgegenhaltungen:
- EP-A- 0 803 902
- EP-A- 0 974 847
- US-A- 4 961 053
- US-A- 5 241 266
- US-A- 5 355 081
- PATENT ABSTRACTS OF JAPAN vol. 2000, no. 08, 6. Oktober 2000 (2000-10-06) -& JP 2000 137059 A (MITSUBISHI ELECTRIC CORP), 16. Mai 2000 (2000-05-16)

## Beschreibung

Die vorliegende Erfindung betrifft ein Verfahren gemäß dem Oberbegriff des Patentanspruchs 1.

Integrierte Schaltungen und Verfahren zu deren Herstellung sind seit vielen Jahren in den unterschiedlichsten Ausführungsformen bekannt.

Ebenfalls bekannt ist, daß integrierte Schaltungen, integrierte Schaltungen enthaltende Halbleiter-Chips, oder Halbleiter-Chips enthaltende Bauteile während oder nach deren Herstellung getestet werden müssen.

Dabei werden nicht ordnungsgemäß arbeitende integrierte Schaltungen durch Deaktivierung der fehlerhaften Teile und Aktivierung von gleichwertigen redundanten Teilen repariert (dies ist insbesondere bei Speicherbausteinen häufig der Fall), oder - sofern dies nicht möglich ist - ausgesondert.

Zum Testen von integrierten Schaltungen sind verschiedene Möglichkeiten bekannt.

Die am weitesten verbreitete Methode besteht darin, die noch auf dem Wafer befindlichen integrierten Schaltungen, oder die bereits aus dem Wafer herausgeschnittenen Halbleiter-Chips, oder die bereits mit einem Gehäuse versehenen Halbleiter-Chips mit einem externen Testgerät zu verbinden und unter Zuführung geeigneter Testsignale zu testen.

Zusätzlich oder alternativ kann das Testen von integrierten Schaltungen auch unter Verwendung von in den integrierten Schaltungen integrierten Selbsttestvorrichtungen erfolgen, welche häufig auch als Build-In-Self-Test-Module bzw. BIST-Module bezeichnet werden. Besonders effizient arbeitende BIST-Module sind beispielsweise aus der EP 0 492 624 A1, der US 5 388 104, der EP 0 568 239 A2, der US 5 570 374, und aus Sampath Rangarajan et al.: "Buit-In Testing of Integrated Circuit Wafers", IEEE Transactions on Computers, vol. 39, No. 2, Februar 1990, Seiten 195 ff. bekannt. Mit Hilfe solcher oder anderer BIST-Module können sich die integrierten Schaltungen zumindest teilweise selbst auf Fehlerfreiheit überprüfen.

Die Erfahrung zeigt, daß das Testen von integrierten Schaltungen trotz der immer besseren und effizienteren Testverfahren zunehmend komplizierter und aufwendiger wird. Verantwortlich hierfür sind insbesondere,
- daß die Taktfrequenz, mit welcher die integrierten Schaltungen betrieben werden, kontinuierlich zunimmt (dies macht es zunehmend aufwendiger, die Tests unter den realen Betriebsbedingungen durchzuführen),
- daß die Taktfrequenz, mit welcher die integrierten Schaltungen betrieben werden, weniger stark zunimmt als die Anzahl der zu testenden Bestandteile wie beispielsweise der Speicherzellen eines zu testenden Speichers der integrierten Schaltung (dies führt zu einer zunehmend länger werdenden Testzeit), und
- daß die Zahl der in den integrierten Schaltung vorhandenen Bauelemente stark zunimmt, wohingegen die Zahl der Ein- und/oder Ausgabeanschlüsse der integrierten Schaltungen vergleichsweise wenig zunimmt (dies führt zu einer zunehmend schwieriger und zeitaufwendiger werdenden Beobachtbarkeit der integrierten Schaltung).

Die immer komplizierter und zeitaufwendiger werdenden Tests von integrierten Schaltungen haben den negativen Effekt, daß das Testen der integrierten Schaltungen immer höhere Kosten verursacht. Dies ist verständlicherweise ein Nachteil.

Neben den vorstehend bereits genannten Dokumenten befassen sich auch die EP A 0 974 847, die US A 4 961 053, die JP 2000 137059 A, sowie die EP A 0 803 902 mit dem Testen von integrierten Schaltungen. Auch diesen Dokumenten ist jedoch keine zufriedenstellende Lösung des vorstehend angesprochenen Problems entnehmbar.

Der vorliegenden Erfindung liegt daher die Aufgabe zugrunde, eine Möglichkeit zu finden, welche es gestattet, daß integrierte Schaltungen schnell und einfach getestet werden können.

Diese Aufgabe wird erfindungsgemäß durch das in Patentanspruch 1 beanspruchte Verfahren gelöst.

Durch das erfindungsgemäße Verfahren kann erreicht werden, daß die Verweildauer der integrierten Schaltung an der externen Testvorrichtung minimal ist, die externe Testvorrichtung also höchst effizient genutzt wird.

Vorteilhafte Weiterbildungen der Erfindung sind den Unteransprüchen, der folgenden Beschreibung und den Figuren entnehmbar.

Die Erfindung wird nachfolgend anhand von Ausführungsbeispielen unter Bezugnahme auf die Figuren näher erläutert. Es zeigen
- Figur 1: den Aufbau einer eine Selbsttestvorrichtung enthaltenden integrierten Schaltung,
- Figur 2: den Aufbau eines von der Selbsttestvorrichtung beschriebenen Testergebnis-Speichers der integrierten Schaltung gemäß Figur 1,
- Figuren 3A und 3B: den Aufbau von zwischen der Selbsttestvorrichtung und dem Testergebnis-Speicher vorgesehenen Schnittstellenschaltungen,
- Figur 4: eine Anordnung, durch welche nach der Beendigung des Selbsttests automatisch die Versorgungsspannungs-Zufuhr zu bestimmten Teilen der integrierten Schaltung unterbrochen wird,
- Figur 5: die beim Testen der integrierten Schaltung gemäß Figur 1 beim Testen derselben durch die Selbsttestvorrichtung auftretenden Verläufe bestimmter Spannungen und Signale,
- Figur 6: eine Anordnung, durch welche Rücksetzsignale zum Rücksetzen von Teilen der integrierten Schaltung abhängig vom Verlauf der Versorgungsspannung für die rückzusetzenden Teile der integrierten Schaltung erzeugt werden,
- Figur 7: einen eine Vielzahl von integrierten Schaltungen tragenden Wafer,
- Figur 8: den Aufbau einer der integrierten Schaltungen des Wafers gemäß Figur 7,
- Figur 9: elektrische Verbindungen, über welche die integrierten Schaltungen des Wafers gemäß Figur 7 miteinander verbunden sind,
- Figuren 10A und 10B: eine Wafer-Kontaktiervorrichtung, durch welche auf dem Wafer gemäß Figur 7 vorgesehene Kontaktstellen kontaktiert werden können,
- Figuren 11A bis 11C: eine Vorrichtung, durch welche ein auf einem Träger liegender Wafer ohne Unterbrechung der Zuführung von ihm zuzuführenden Spannungen oder Signalen vom Träger abnehmbar ist,
- Figur 12: eine Testbox, in welcher die integrierten Schaltungen von mehreren Wafern gleichzeitig durch die in ihnen enthaltenen Selbsttestvorrichtungen testbar sind,
- Figur 13: eine Anordnung, bei welcher die zu testenden integrierten Schaltungen auf einem Drehteller zu einer externen Testvorrichtung transportiert und auf dem Weg dorthin durch die in ihnen enthaltenen Selbsttestvorrichtungen getestet werden,
- Figur 14: eine Anordnung, durch welche sich Halbleiter-Chips enthaltende Bauteile effizient testen lassen, und
- Figuren 15A und 15B: verschiedene Ansichten eines in der Anordnung gemäß Figur 14 zum Einsatz kommenden Bauteil-Trägers.

Durch die nachfolgend näher beschriebenen Maßnahmen lassen sich integrierte Schaltungen schnell und einfach testen. Die Maßnahmen betreffen
- den Aufbau der zu testenden integrierten Schaltung,
- den zur gleichzeitigen Herstellung mehrerer integrierter Schaltungen dienenden und am Ende eine Vielzahl von integrierten Schaltungen tragenden Wafer, sowie
- die Verfahren und Vorrichtungen zum Testen der integrierten Schaltungen,
wobei sich die integrierten Schaltungen besonders schnell und einfach testen lassen, wenn von allen beschriebenen Besonderheiten Gebrauch gemacht wird. Es sei jedoch bereits an dieser Stelle darauf hingewiesen, daß sich integrierte Schaltungen auch dann schneller und einfacher als bisher testen lassen, wenn nur von einzelnen oder mehreren der im folgenden beschriebenen Besonderheiten Gebrauch gemacht wird.

Die zu testenden integrierten Schaltungen sind im betrachteten Beispiel in CMOS-Technik realisierte Halbleiter-Schaltungen (systems on silicon), können aber auch beliebige andere Schaltungen sein; sie sind Bestandteil eines Halbleiter-Chips oder werden noch zu einem Halbleiter-Chip weiterverarbeitet. Die Funktion der zu testenden integrierten Schaltungen ist keinen Beschränkungen unterworfen.

Die betrachteten integrierten Schaltungen enthalten eine Selbsttestvorrichtung, unter Verwendung welcher sie gewisse Komponenten oder Funktionen von sich testen können. Die Selbsttestvorrichtung ist im betrachteten Beispiel ein sogenanntes Build-In-Self-Test-Modul bzw. BIST-Modul.

Wie später noch genauer beschrieben werden wird, führt das BIST-Modul im Ansprechen auf eine externe Aufforderung einen Test der von ihm testbaren Komponenten und Funktionen der integrierten Schaltung (beispielsweise eines in der integrierten Schaltung enthaltenen Speichers) durch und schreibt das Ergebnis dieses Selbsttests in einen (ebenfalls in der integrierten Schaltung enthaltenen) Testergebnis-Speicher. Das im Testergebnis-Speicher gespeicherte Testergebnis wird durch die integrierte Schaltung auf Veranlassung durch eine externe Testvorrichtung an diese ausgegeben und dort ausgewertet; diese externe Testvorrichtung ist im betrachteten Beispiel eine Testvorrichtung, die neben der Auswertung der Ergebnisse des Selbsttests der integrierten Schaltung zusätzlich diejenigen Komponenten oder Funktionen der integrierten Schaltung, die durch das BIST-Modul nicht oder nur teilweise getestet werden (können), durch Zuführung geeigneter Signale und unter Auswertung der Reaktion hierauf testet.

Im betrachteten Beispiel wird der Test der integrierten Schaltung durch das darin enthaltene BIST-Modul bereits begonnen, bevor die integrierte Schaltung an die externe Testvorrichtung angeschlossen ist, beispielsweise bereits während einer Zwischenlagerung der betreffenden integrierten Schaltung und/oder während des Transports der betreffenden integrierten Schaltung zur externen Testvorrichtung; der Test der integrierten Schaltung durch das darin enthaltene BIST-Modul ist vorzugsweise bereits abgeschlossen, wenn die integrierte Schaltung an die externe Testvorrichtung angeschlossen wird.

Dadurch kann die externe Testvorrichtung nach der Herstellung der Verbindung mit der zu testenden integrierten Schaltung sofort
- mit dem Auslesen und Auswerten der Ergebnisse des durch das BIST-Modul ausgeführten Tests, und
- mit dem Testen von durch das BIST-Modul nicht getesteten Komponenten und Funktionen der zu testenden integrierten Schaltung
beginnen.

Da die externe Testvorrichtung die Einleitung des durch das BIST-Moduls durchzuführenden Tests nicht selbst vornehmen und anschließend bis zum Ende dieses Tests warten muß, bis sie mit dem Auslesen und Auswerten der Ergebnisse des durch das BIST-Modul ausgeführten Tests und/oder mit dem Weitertesten der zu testenden integrierten Schaltung beginnen kann, sind die Verweildauer der zu testenden integrierten Schaltung an der externen Testvorrichtung minimal, und die Ausnutzung der externen Testvorrichtung optimal.

Die Verkürzung der Verweildauer der zu testenden integrierten Schaltung an der externen Testvorrichtung mag unbedeutend erscheinen. Berücksichtigt man jedoch die immense Anzahl von integrierten Schaltungen, die durch die externe Testvorrichtung im Lauf der Zeit zu testen sind, so ergibt sich selbst dann, wenn pro integrierter Schaltung nur ein Bruchteil einer Sekunde eingespart werden kann, eine enorme Zeitersparnis.

Das Einleiten und die Durchführung des durch das BIST-Modul auszuführenden Tests ohne Mitwirkung durch die externe Testvorrichtung bereitet keinerlei Probleme: wie später noch besser verstanden werden wird, müssen hierfür nur einige wenige Anschlüsse der integrierten Schaltung kontaktiert und mit zur Einleitung des Tests benötigten Spannungen und Signalen beaufschlagt werden; der Test selbst kann selbständig (ohne eine externe Steuerung) ablaufen.

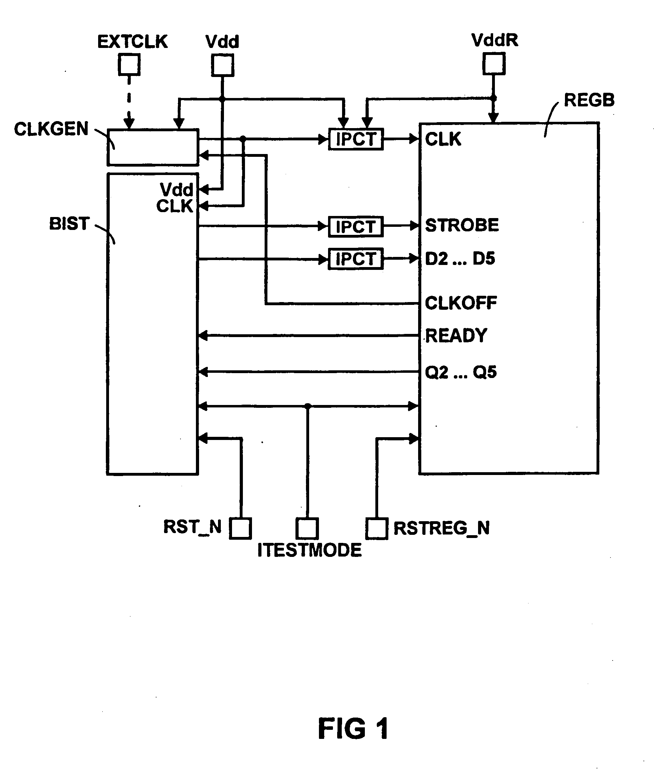

Eine integrierte Schaltung, die für die vorstehend beschriebene Vorgehensweise besonders gut geeignet ist, ist in Figur 1 dargestellt. Der Vollständigkeit halber sei angemerkt, daß von dieser integrierten Schaltung nur das BIST-Modul, der Testergebnis-Speicher und die zu deren ordnungsgemäßen Betrieb benötigten Bestandteile der integrierten Schaltung gezeigt sind und beschrieben werden.

Die in der Figur 1 gezeigte integrierte Schaltung enthält eine Selbsttestvorrichtung in Form eines BIST-Moduls BIST, einen im betrachteten Beispiel durch einen Register-Block REGB gebildeten Testergebnis-Speicher, mehrere Schnittstellenschaltungen IPCT, und durch sogenannte Pads gebildete Eingangsanschlüsse zur Zuführung eines externen Taktsignals EXTCLK, einer die integrierte Schaltung mit Ausnahme des Register-Blocks REGB mit Energie versorgenden ersten Versorgungsspannung Vdd, einer nur den Register-Block REGB mit Energie versorgenden zweiten Versorgungsspannung VddR, eines das BIST-Modul BIST steuernden Steuersignals RST_N, eines das BIST-Modul BIST und den Register-Block REGB steuernden Steuersignals ITESTMODE, und eines den Register-Block REGB steuernden Steuersignals RSTREG_N, wobei der Anschluß für das externe Taktsignal EXTCLK entfallen kann, wenn die integrierte Schaltung über einen internen Taktsignalgenerator CLKGEN verfügt, was vorliegend der Fall sein möge.

Das BIST-Modul BIST
- wird durch die bereits erwähnte erste Versorgungsspannung Vdd mit Energie versorgt,
- wird durch ein vom internen Taktsignalgenerator CLKGEN erzeugtes Taktsignal CLK getaktet,
- erhält von außerhalb der integrierten Schaltung die bereits erwähnten Steuersignale ITESTMODE und RST_N,
- erhält vom Register-Block REGB ein Steuersignal READY, und Daten Q2 bis Q5, und
- gibt an den Register-Block REGB ein Steuersignal STROBE, und Daten D2 bis D5 aus.

Der Register-Block REGB
- wird durch die bereits erwähnte zweite Versorgungsspannung VddR mit Energie versorgt,
- wird durch ein vom internen Taktsignalgenerator CLKGEN erzeugtes Taktsignal CLK getaktet,
- erhält von außerhalb der integrierten Schaltung die bereits erwähnten Steuersignale ITESTMODE und RSTREG_N,
- erhält vom BIST-Modul BIST das Steuersignal STROBE und die Daten D2 bis D5,
- gibt an das BIST-Modul BIST das Steuersignal READY und die Daten Q2 bis Q5 aus, und
- gibt an den internen Taktsignalgenerator CLKGEN oder eine auf das externe Taktsignal EXTCLK Einfluß nehmen könnende Einrichtung ein Steuersignal CLKOFF aus.

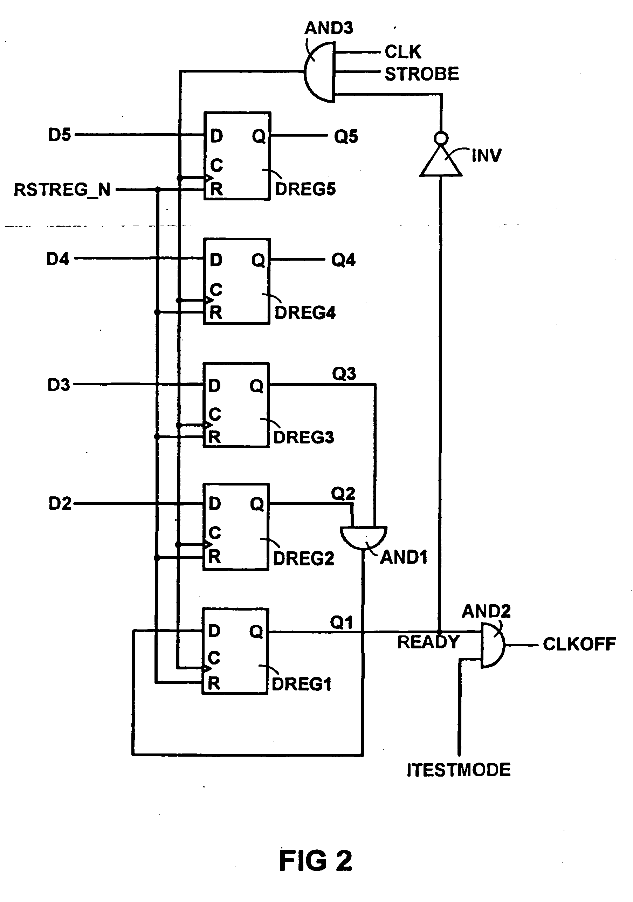

Der Aufbau des Register-Blocks REGB ist in Figur 2 gezeigt. Der Register-Blocks REGB enthält im betrachteten Beispiel
- mehrere (im betrachteten Beispiel fünf) Register DREG1 bis DREG5,
- UND-Glieder AND1 bis AND3, und
- einen Inverter INV.

Von den Registern DREG1 bis DREG5 enthält jedes einen Dateneingabeanschluß D, einen Datenausgabeanschluß Q, einen Rücksetzanschluß R, und einen Taktanschluß C, wobei
- in den Dateneingabeanschluß D des Registers DREG1 das Ausgangssignal des ersten UND-Gliedes AND1 eingegeben wird,
- in die Dateneingabeanschlüsse D der Register DREG2 bis DREG5 die Daten D2 bis D5 eingegeben werden,
- aus dem Datenausgabeanschluß Q des Registers DREG1 das (als Signal READY verwendete) Datum Q1 ausgegeben wird,
- aus den Datenausgabeanschlüssen Q der Register DREG2 bis DREG5 die Daten Q2 bis Q5 ausgegeben werden,
- an die Rücksetzanschlüsse R der Register DREG1 bis DREG5 das Signal RSTREG_N angelegt wird,
- an die Taktanschlüsse C der Register DREG1 bis DREG5 das Ausgangssignal des dritten UND-Gliedes AND3 angelegt wird,
- das erste UND-Glied AND1 eine UND-Verknüpfung der aus den Ausgangsanschlüssen Q der Register DREG2 und DREG3 ausgegebenen Daten Q2 und Q3 durchführt,
- das zweite UND-Glied AND2 eine UND-Verknüpfung der Signale READY und ITESTMODE durchführt und das Signal CLKOFF erzeugt, und
- das dritte UND-Glied AND3 eine UND-Verknüpfung der Signale CLK, STROBE und invertiertem READY durchführt.

Die bereits erwähnten Schnittstellenschaltungen IPCT sind den Eingangsanschlüssen des Register-Blocks REGB für die innerhalb der integrierten Schaltung erzeugten Signale, also für die Signale CLK, STROBE, D2, D3, D4 und D5 vorgeschaltet. Ihre Aufgabe ist es, dafür zu sorgen, daß die genannten Signale auch dann, wenn die die Signale erzeugenden Einrichtungen deaktiviert sind, was, wie später noch genauer beschrieben wird, insbesondere dann der Fall ist, wenn die diese Einrichtungen mit Energie versorgende Versorgungsspannung Vdd abgeschaltet ist, definierte Zustände oder Verläufe annehmen; die genannten Signale dürfen nicht floaten.

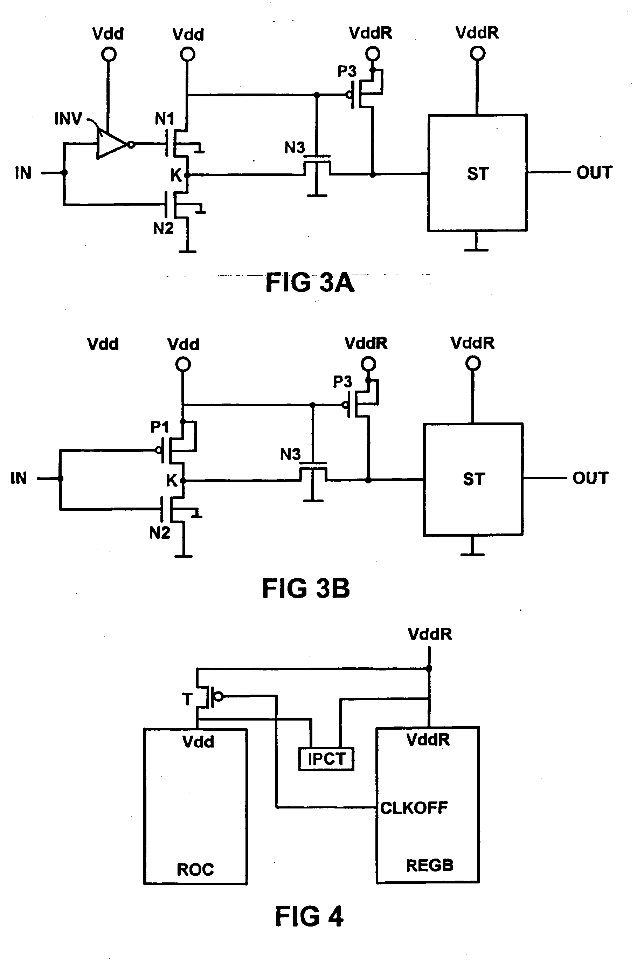

Zwei Möglichkeiten zur praktischen Realisierung solcher Schnittstellenschaltungen sind in Figur 3A und Figur 3B gezeigt. Diese Schaltungen sorgen dafür, daß dem Register-Block REGB sowohl bei anliegender Versorgungsspannung Vdd als auch bei abgeschalteter Versorgungsspannung Vdd definierte Potentiale, genauer gesagt VddR oder 0V zugeführt werden.

Die in den Figuren 3A und 3B gezeigten Schnittstellenschaltungen IPCT unterscheiden sich "nur" im Aufbau der Eingangsstufe derselben; dies hat aber keinen Einfluß auf ihre Funktion und Wirkungsweise.

Die in den Figuren 3A und 3B gezeigten Schnittstellenschaltungen IPCT funktionieren wie folgt:

Bei anliegender Versorgungsspannung Vdd (=VddR) wird das an einem Eingangsanschluß IN anliegende Signal invertiert auf einen Knoten K, und von diesem weiter über einen Transistor N3 zu einem Schmitt-Trigger ST übertragen, welcher abhängig vom Potential des ihm zugeführten Signals (und damit auch abhängig von dem dem Eingangsanschluß IN der Schnittstellenschaltung IPCT zugeführten Signal) VddR oder 0V ausgibt, und dessen Ausgangssignal OUT zugleich das Ausgangssignal der jeweiligen Schnittstellenschaltung IPCT ist.

Wenn Vdd abgeschaltet ist, sperrt der Transistor N3, und wird dem Schmitt-Trigger ST über einen Transistor P3 die Spannung VddR zugeführt, wodurch unabhängig von dem dem Eingangsanschluß IN der Schnittstellenschaltung IPCT zugeführten Signal VddR aus dem Schmitt-Trigger ST und der Schnittstellenschaltung IPCT ausgegeben wird.

Das Testen der integrierten Schaltung durch das BIST-Modul BIST läuft wie folgt ab:

Zu Beginn des Tests werden beide Versorgungsspannungen Vdd und VddR und Steuersignale ITESTMODE=1, RST_N=0, und RSTREG_N=0 angelegt, wobei
- RST_N=0 das BIST-Modul BIST zurücksetzt,
- RSTREG_N=0 die Register DREG1 bis DREG5 zurücksetzt, und
- ITESTMODE=1 das BIST-Modul (nach erfolgtem Rücksetzen desselben) zum Testen der integrierten Schaltung veranlaßt.

Nach Ablauf einer Zeit, innerhalb welcher das BIST-Modul BIST und die Register DREG1 bis DREG5 durch die Signale RST_N=0 und RSTREG_N=0 zuverlässig zurückgesetzt sind, werden die Signale RST_N und RSTREG_N auf den Wert 1 gesetzt.

Wenn der auf das Signal ITESTMODE=1 hin durch das BIST-Modul ausgeführte Test der integrierten Schaltung abgeschlossen ist, überträgt das BIST-Modul
- das Testergebnis repräsentierende Daten, und
- den Teststatus repräsentierende Daten
zum Register-Block REGB.

Im betrachteten Beispiel werden vom BIST-Modul zwei Einzeltests ausgeführt, und werden für jeden Einzeltest Testergebnis-Daten und ein Teststatus-Daten erzeugt, wobei diese Daten jeweils aus einem Bit bestehen, und wobei
- Testergebnis-Daten mit dem Wert 0 anzeigen, daß der betreffende Test nicht bestanden wurde,
- Testergebnis-Daten mit dem Wert 1 anzeigen, daß der betreffende Test erfolgreich bestanden wurde,
- Teststatus-Daten mit dem Wert 0 anzeigen, daß der betreffende Test noch nicht beendet ist, und
- Teststatus-Daten mit dem Wert 1 anzeigen, daß der betreffende Test beendet ist.

Im betrachteten Beispiel sind die Testergebnis-Daten die Daten D4 und D5, und die Teststatus-Daten die Daten D2 und D3.

Es sei bereits an dieser Stelle darauf hingewiesen, das BIST-Modul BIST prinzipiell beliebig viele Einzeltests durchführen kann, und daß die über die Tests zum Register-Block REGB ausgegebenen Daten prinzipiell beliebig viele, beliebig lange, beliebig codierte, und beliebige Informationen repräsentierende Daten sein können.

Die vom BIST-Modul BIST an den Register-Block REGB ausgegebenen Daten werden, wenn vom BIST-Modul BIST gleichzeitig das bereits erwähnte STROBE-Signal, genauer gesagt STROBE=1 ausgegeben wird, mit der jeweils nächsten steigenden Flanke des Taktsignals CLK in die Register DREG2 bis DREG5 übernommen und in diesen gespeichert. Über das STROBE-Signal kann das BIST-Modul BIST Einfluß darauf nehmen, ob und gegebenenfalls wann Daten im Register-Block REGB gespeichert werden. Dadurch kann erreicht werden, daß in den Register-Block nicht irrtümlich falsche Daten eingeschrieben werden, und daß der Energieverbrauch im Register-Block nicht höher als unbedingt notwendig ist.

Wenn das BIST-Modul BIST die zwei von ihr auszuführenden Einzeltests fertig ausgeführt hat, steht in den Registern DREG2 und DREG3 jeweils der Wert 1. Die Inhalte dieser Register werden durch das erste UND-Glied AND1 einer UND-Verknüpfung unterzogen, und das Ergebnis dieser UND-Verknüpfung wird in das Register DREG1 geschrieben. Der im Register DREG1 gespeicherte Wert zeigt somit an, ob das BIST-Modul BIST alle von ihr auszuführenden Einzeltests fertig ausgeführt hat; ein DREG1-Inhalt 0 zeigt an, daß noch nicht alle Tests fertig ausgeführt sind, und ein DREG1-Inhalt 1 zeigt an, daß alle Tests ausgeführt wurden.

Der am Ausgangsanschluß Q des Registers DREG1 abgreifbare Inhalt desselben ist das bereits erwähnte READY-Signal, welches vom Register-Block REGB zum BIST-Modul BIST ausgegeben wird.

Vom READY-Signal hängt es darüber hinaus auch ab, welchen Wert das Signal CLKOFF aufweist, und ob den Taktanschlüssen C der Register DREG1 bis DREG5 ein Taktsignal zugeführt wird.

Das Signal CLKOFF ist das Ergebnis der durch das UND-Glied AND2 erfolgenden UND-Verknüpfung der Signale READY und ITESTMODE, und ob den Taktanschlüssen der Register DREG1 bis DREG5 ein Taktsignal zugeführt wird, hängt vom Ergebnis der durch das UND-Glied AND3 erfolgenden UND-Verknüpfung des negierten READY-Signals und der Signale STROBE und CLK ab.

Das Signal CLKOFF wird 1, wenn sich die integrierte Schaltung in der Test-Betriebsart befindet (ITESTMODE=1) und der durch das BIST-Modul durchzuführende Test beendet ist (READY=1), und wird dazu verwendet, die Zuführung des Taktsignals CLK zum Register-Block REGB und zu den restlichen Komponenten der integrierten Schaltung zu unterbinden. Dadurch kann die integrierte Schaltung nach der Beendigung des durch das BIST-Modul durchzuführenden Tests automatisch in einen Zustand versetzt werden, in welchem sie einen minimalen Energieverbrauch aufweist.

Noch besser ist es, wenn CLKOFF=1 zusätzlich oder alternativ dazu verwendet wird, die Zufuhr der Versorgungsspannung Vdd, durch welche die integrierte Schaltung mit Ausnahme des Register-Blocks REGB mit Energie versorgt wird, automatisch abzuschalten. Eine Möglichkeit zur praktischen Realisierung hierzu besteht darin, daß für das Signal CLKOFF ein Ausgangsanschluß der integrierten Schaltung (ein Pad) vorgesehen wird, und daß durch das über diesen Pad ausgegebene Signal ein außerhalb der integrierten Schaltung im Vdd-Pfad vorgesehener und beispielsweise durch einen Transistor gebildeter Schalter betätigt wird. Eine andere Möglichkeit zur Versorgungsspannungs-Abschaltung ist Figur 4 dargestellt. Bei der in der Figur 4 dargestellten integrierten Schaltung wird der der Schalter, durch welchen Vdd zu- oder abgeschaltet wird, durch einen innerhalb der integrierten Schaltung vorgesehenen und von CLKOFF gesteuerten Transistor T gebildet. Dies hat den positiven Effekt, daß der integrierten Schaltung nur eine einzige Versorgungsspannung (im betrachteten Beispiel VddR) von außen zugeführt werden muß; diese einzige Versorgungsspannung wird sowohl dem Register-Block als auch - über den Transistor T - dem mit ROC bezeichneten Rest der integrierten Schaltung zugeführt.

Die Unterbrechung der Zufuhr von Vdd in Zeiten, zu welchen die integrierte Schaltung nichts anderes zu tun hat, als dafür zu sorgen, daß die im Register-Block REGB gespeicherten Daten nicht verloren gehen, was beispielsweise zwischen dem Ende des vom BIST-Modul durchgeführten Test und dem Erreichen der den Test der integrierten Schaltung fortsetzenden externen Testvorrichtung der Fall ist, erweist sich als vorteilhaft, weil dadurch die Energieaufnahme der integrierten Schaltung reduziert werden kann, was insbesondere dann, wenn der vom BIST-Modul durchgeführte Test für alle integrierte Schaltungen eines oder mehrerer Wafer gleichzeitig durchgeführt wird, von großer Bedeutung ist.

Daß, wie vorstehend bereits erwähnt wurde, an die Taktanschlüsse C der Register DREG1 bis DREG5 ein Signal angelegt wird, welches das Ergebnis einer UND-Verknüpfung der Signale CLK, STROBE, und des invertierten Signals READY ist, hat den positiven Effekt,
- daß in die Register DREG1 bis DREG5 nur Daten eingeschrieben werden können, wenn das BIST-Modul dies durch Ausgabe von STROBE=1 zuläßt, und
- daß das Einschreiben von Daten in die Register DREG1 bis DREG5 automatisch unterbunden wird, wenn die vom BIST-Modul durchzuführenden Tests abgeschlossen sind.

Die Möglichkeiten,
- daß der Register-Block REGB in Betrieb gehalten werden kann, während der Rest der integrierten Schaltung deaktiviert oder abgeschaltet ist, und
- daß durch den vorstehend beschriebenen Selbstverriegelungsmechanismus gewährleistet ist, daß die im Register-Block REGB gespeicherten Ergebnisse des vom BIST-Modul durchgeführten Tests nach dem Abschluß des Tests unter keinen Umständen mehr überschrieben werden können,
schaffen ideale Voraussetzungen dafür, daß die im Register-Block REGB gespeicherten Daten zu einem beliebigen Zeitpunkt nach dem Testende ausgelesen und ausgewertet werden können.

Zum Auslesen der im Register-Block REGB gespeicherten Daten und Ausgeben derselben aus der integrierten Schaltung (beispielsweise an die externe Testvorrichtung) werden ITESTMODE=0 und RST_N=0 gesetzt; das Signal RSTREG_N bleibt auf dem Wert 1.

Das Umschalten des Signals ITESTMODE auf den Wert 0 bewirkt, daß das abhängig davon generierte Signal CLKOFF ebenfalls den Wert 0 annimmt. Dies hat den Effekt, daß wieder die gesamte integrierte Schaltung mit Energie versorgt wird, und/oder daß das Taktsignal CLK wieder erzeugt (bei internem Taktsignalgenerator) bzw. weitergeleitet (bei externem Taktsignalgenerator) wird.

Da das Signal READY dabei den Wert 1 behält, können die Register DREG1 bis DREG5 aber nach wie vor nicht beschrieben werden.

Durch das Signal RST_N=0 wird das BIST-Modul zurückgesetzt. Das Signal RST_N wird zu einem Zeitpunkt, zu dem davon ausgegangen werden kann, daß das BIST-Modul zurückgesetzt ist, wieder auf den Wert 1 gesetzt. Danach ist es möglich, die integrierte Schaltung zum Auslesen der im Register-Block REGB gespeicherten Daten und zur Ausgabe dieser Daten (Daten Q2 bis Q5) zu veranlassen.

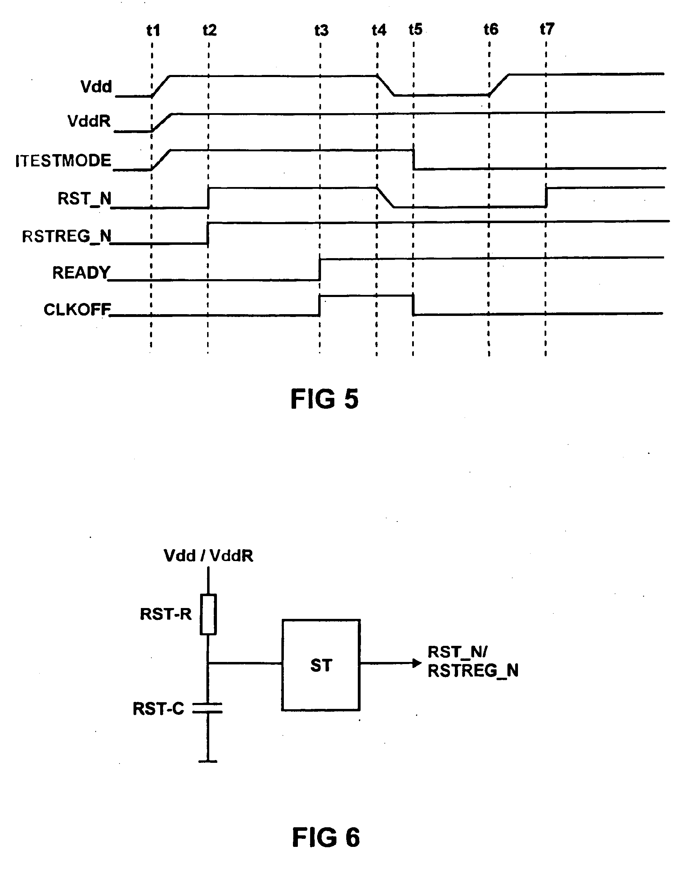

Die vorstehend beschriebenen Vorgänge sind in Figur 5, welche die zeitlichen Verläufe von Vdd, VddR, ITESTMODE, RST_N, RSTREG_N, READY, und CLKOFF zeigt, veranschaulicht. Von den in der Figur 5 markierten Zeitpunkten bezeichnen
- t1: den Zeitpunkt, zu dem die integrierte Schaltung in Betrieb genommen wird,
- t2: den Zeitpunkt, zu dem das Rücksetzen der integrierten Schaltung abgeschlossen ist und der Test der integrierten Schaltung durch das BIST-Modul beginnt,
- t3: den Zeitpunkt zu dem der Selbsttest abgeschlossen ist,
- t4: den Zeitpunkt, zu dem Vdd abgeschaltet wird,
- t5: den Zeitpunkt, zu dem mit den Vorbereitungen für das Auslesen des Testergebnis-Speichers begonnen wird,
- t6: den Zeitpunkt, zu dem Vdd wieder eingeschaltet wird, und
- t7: den Zeitpunkt, zu dem mit dem Auslesen des Testergebnis-Speichers begonnen werden kann.

Wie aus den vorstehenden Erläuterungen ersichtlich ist, müssen zum Testen der integrierten Schaltung durch das in dieser enthaltene BIST-Modul nur sehr wenige Ein- und/oder Ausgabeanschlüsse der integrierten Schaltung kontaktiert werden. Die Anzahl der zu kontaktierenden Ein- und/oder Ausgabeanschlüsse kann sogar noch weiter reduziert werden, wenn die Rücksetzsignale RST_N und RSTREG_N innerhalb der integrierten Schaltung abhängig vom Verlauf der Versorgungsspannungen Vdd und VddR erzeugt werden. Eine Schaltung, durch welche dies beispielsweise bewerkstelligt werden kann, ist in Figur 6 gezeigt und besteht aus einem Widerstand RST-R, einem Kondensator RST-C, und einem Schmitt-Trigger ST. Macht man von dieser Möglichkeit Gebrauch, so können die für die Signale RST_N und RSTREG_N vorgesehenen Eingangsanschlüsse (Pads) der integrierten Schaltung entfallen, und müssen zum Testen der integrierten Schaltung durch das darin enthaltene BIST-Modul noch weniger Ein- und/oder Ausgangsanschlüsse der integrierten Schaltung kontaktiert werden, als es ohnehin schon der Fall ist.

Die über die Versorgungsspannung VddR erfolgende Versorgung des Register-Blocks REGB mit Energie wird mindestens bis zum Anschluß der integrierten Schaltung an die externe Testvorrichtung und zum Auslesen der im Register-Block gespeicherten Daten durch die externe Testvorrichtung ununterbrochen aufrechterhalten. Die Spannungsquelle, die die Versorgungsspannung VddR liefert, und/oder die Kontaktelemente, über welche die Versorgungsspannung VddR an die integrierte Schaltung abgelegt wird, können dabei jedoch wechseln; dies ist beispielsweise dann, wenn die integrierte Schaltung von einer diese zur externen Testvorrichtung transportierenden Transportvorrichtung genommen wird, um durch eine andere Transportvorrichtung weitertransportiert zu werden, oder um zwischengelagert zu werden, oder um an die Testvorrichtung angeschlossen zu werden, nahezu unumgänglich. In Fällen, in welchen dies zu aufwendig oder nicht möglich ist, kann die Versorgung der integrierten Schaltung mit der Versorgungsspannung VddR über eine mit der integrierten Schaltung verbundene und mit dieser mitgeführte Batterie oder einen Kondensator erfolgen. Hierauf wird später noch genauer eingegangen.

Darüber hinaus muß natürlich dafür gesorgt werden, daß der integrierten Schaltung während des durch das BIST-Modul durchgeführten Tests die Steuersignale RST_N, RSTREG_N, und ITESTMODE, und gegebenenfalls das Taktsignal CLK zugeführt werden. Dies kann durch eine sehr einfach aufgebaute Steuervorrichtung geschehen, die im Fall, daß der Test während des Transports der integrierten Schaltung zur externen Testvorrichtung erfolgt, vorzugsweise eine zumindest während des Tests mit der integrierten Schaltung mitführbare Steuereinrichtung ist.

Der durch das BIST-Modul durchzuführende Test wird vorzugsweise in mehreren integrierten Schaltungen, beispielsweise in allen integrierten Schaltungen eines oder mehrerer Wafer gleichzeitig durchgeführt.

Die gleichzeitige Durchführung des durch das BIST-Modul durchzuführende Tests in allen integrierten Schaltungen eines Wafers läßt sich bei einem wie nachfolgend beschriebenen Wafer besonders einfach realisieren.

Ein solcher Wafer zeichnet sich unter anderem dadurch aus, daß von den darauf hergestellten integrierten Schaltungen zumindest diejenigen Stellen der integrierten Schaltungen, denen zum Testen derselben durch die BIST-Module die dazu erforderlichen Spannungen und Signale zugeführt werden müssen, elektrisch miteinander verbunden sind.

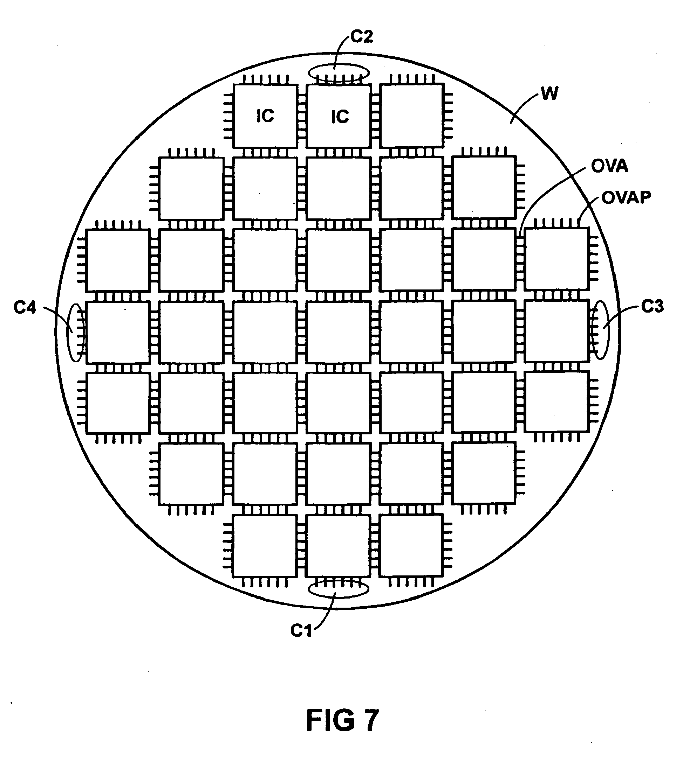

Ein solcher Wafer ist in Figur 7 dargestellt. Dabei sind der Wafer mit dem Bezugszeichen W, die darauf hergestellten integrierten Schaltungen mit dem Bezugszeichen IC, und die elektrischen Verbindungen zwischen den integrierten Schaltungen IC mit dem Bezugszeichen OVA bezeichnet. Durch die elektrischen Verbindungen OVA werden im betrachteten Beispiel die Stellen der integrierten Schaltungen miteinander verbunden, welchen die Versorgungsspannungen Vdd und VddR, das Massepotential GND, und die Signale RST_N, RSTREG_N, und ITESTMODE zuzuführen sind.

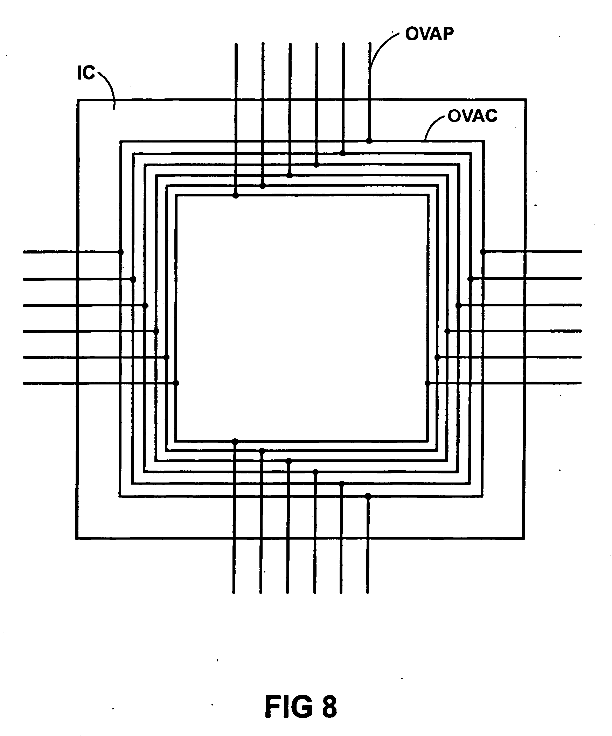

Die elektrischen Verbindungen OVA werden im betrachteten Beispiel durch von den integrierten Schaltungen IC abgehende Leitungsstücke gebildet, die in die zwischen benachbarten integrierten Schaltungen IC vorhandenen Zwischenräume hineinragen und sich dort mit den jeweils zugeordneten Leitungsstücken der benachbarten integrierten Schaltungen überlappen. Solche Leitungsstücke gehen von mehreren, vorzugsweise von allen vier Seiten der integrierten Schaltung ab, wobei die von verschiedenen Seiten der integrierten Schaltung abgehenden Leitungsstücke durch innerhalb oder außerhalb der integrierten Schaltung verlaufende Leitungen miteinander verbunden sind. Eine solche integrierte Schaltung ist beispielhaft in Figur 8 dargestellt; dabei sind die zur Bildung der Verbindungen OVA vorgesehenen Leitungsstücke mit dem Bezugszeichen OVAP, und die diese verbindenden Leitungen mit dem Bezugszeichen OVAC bezeichnet. Es sei bereits an dieser Stelle darauf hingewiesen, daß die die Leitungsstücke OVAP untereinander verbindenden Leitungen OVAC auch einen beliebigen anderen Verlauf aufweisen können und auch außerhalb der integrierten Schaltungen (in den zwischen benachbarten integrierten Schaltungen vorhandenen Zwischenräumen) verlaufen können. Die die Leitungsstücke OVAP miteinander verbindenden Leitungen OVAC sind im betrachteten Beispiel Bestandteil einer der leitfähigen Schichten der integrierten Schaltung, bestehen also beispielsweise aus AlSiCu oder aus mit Ti oder Ti/N ummanteltem Cu.

Die sich über die integrierten Schaltungen hinaus (in die auch als Ritzrahmen bezeichneten Zwischenräume zwischen benachbarten integrierten Schaltungen hinein) erstreckenden Leitungsstücke OVAP werden im betrachteten Beispiel zusammen mit den integrierten Schaltungen hergestellt; in den Arbeitsschritten, in welchen die Leitungsstücke OVAP hergestellt werden, werden Masken (Reticles) verwendet, die einen über den Rand der herzustellenden integrierten Schaltung hinausgehenden Bereich abdecken.

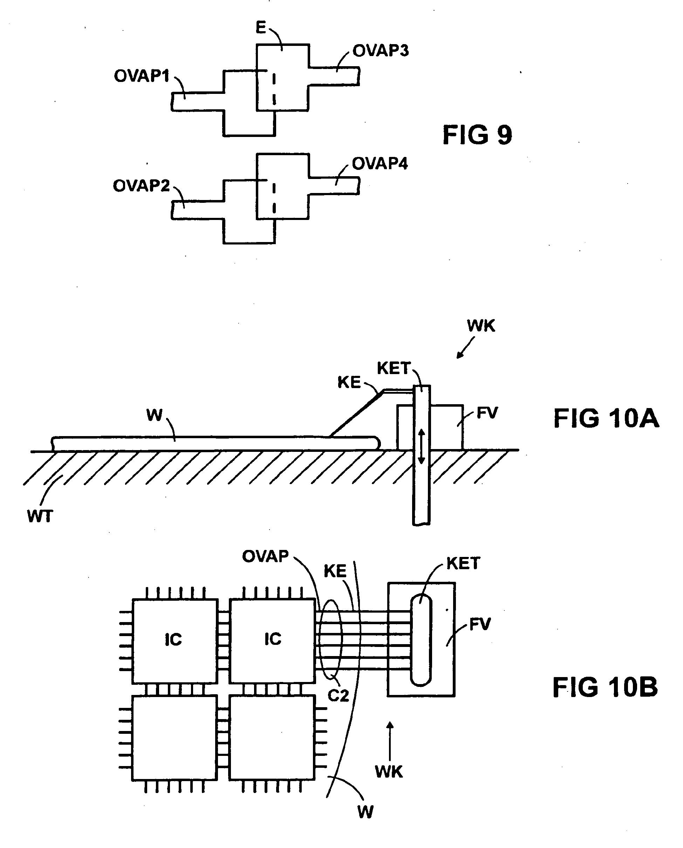

Die integrierten Schaltungen eines Wafers werden in einer Vielzahl von aufeinanderfolgenden Schritten (Abscheidungen, Belichtungen, Ätzungen, Oxidationen, Implantationen, Lithographieschritte etc.) hergestellt, wobei jedoch üblicherweise nicht jeder Schritt für alle integrierten Schaltungen gleichzeitig ausgeführt wird; bestimmte Schritte, beispielsweise das Belichten eines Resist, werden für jede integrierte Schaltung oder für jeweils mehrere integrierte Schaltungen enthaltende Gruppen von integrierten Schaltungen einzeln aufeinanderfolgend ausgeführt. Dies kann dazu führen, daß zwischen integrierten Schaltungen, die nicht zusammen bearbeitet (beispielsweise belichtet) werden, keine ordnungsgemäßen Verbindungen OVA zustande kommen. Dies kann verschiedene Ursachen haben: zum einen kann es vorkommen, daß die einander zugeordneten Leitungsstücke OVAP von benachbarten integrierten Schaltungen oder von benachbarten Gruppen von integrierten Schaltungen, die nicht zusammen belichtet werden, nicht miteinander fluchten, und zum anderen kann es vorkommen, daß die Verbindungen OVA an den Stellen, an welchen sie sich überlappen, durch die doppelte Belichtung an diesen Stellen lokal schmaler oder breiter werden und dadurch so schmal werden, daß keine gute Verbindung zustande kommt, oder so breit werden, daß benachbarte Verbindungen OVA miteinander in Kontakt kommen. Dies kann verhindert werden, indem zwischen benachbarten Leitungsstücke OVAP ein größerer Abstand vorgesehen wird als es bei der verwendeten Technologie üblich ist, und indem die freien (die im Zwischenraum zwischen benachbarten integrierten Schaltungen zu liegen kommenden) Enden der Leitungsstücke OVAP breiter ausgebildet werden als der Rest der Leitungsstücke. Dies ist in Figur 9 veranschaulicht. Figur 9 zeigt Leitungsstücke OVAP1 und OVAP2 einer ersten integrierten Schaltung, und Leitungsstücke OVAP3 und OVAP4 einer nicht zusammen mit der ersten integrierten Schaltung belichteten zweiten integrierten Schaltung. Die Leitungsstücke OVAP1 bis OVAP4 weisen gegenüber dem Rest verbreiterte Endabschnitte E auf. Wie aus der Figur 9 ersichtlich ist, kommen die miteinander in Verbindung zu bringenden Leitungsstücke OVAP1 und OVAP3 bzw. OVAP2 und OVAP4 selbst dann ordnungsgemäß in Kontakt, wenn sie nicht miteinander fluchten; durch die besonders großen Abstände zwischen OVAP1 und OVAP2 bzw. zwischen OVAP3 und OVAP4 besteht auch keine Gefahr, daß Kurzschlüsse entstehen.

Bei einem Wafer, bei dem mehrere oder alle der darauf ausgebildeten integrierten Schaltungen wie beschrieben oder anders miteinander verbunden sind, genügt es, wenn den integrierten Schaltungen zur Einleitung und zur Durchführung des Testens durch die darin enthaltenen BIST-Module zuzuführenden Spannungen und Signale dem Wafer nur an einer einzigen oder an einigen wenigen Stellen, beispielsweise in einer der in der Figur 7 mit den Bezugszeichen C1, C2, C3 und C4 bezeichneten Kontaktzonen zugeführt werden.

Eine Anordnung, durch welche dies geschehen kann, ist in den Figuren 10A und 10B gezeigt. Die Figuren 10A und 10B zeigen einen (Wafer-)Träger bzw. Chuck WT, einen auf dem Träger WT aufgesetzten Wafer W, und einer (Wafer-)Kontaktiervorrichtung WK, wobei die Kontaktiervorrichtung WK eine in Längsrichtung auf- und abbewegbare Stange KET, an der Stange befestigte Kontakt-Nadeln KE, und eine Führungsvorrichtung FV zur Führung der die Kontaktnadeln KE tragende Stange KET umfaßt.

Die Stange KET ist zusammen mit den von ihr getragenen Nadeln KE auf- und abbewegbar. Wenn sich die Stange KET in der unteren Stellung befindet, kommen die Nadeln KE mit den in der kontaktierten Kontaktzone (in einer der Kontaktzonen C1 bis C4) ausgebildeten Kontaktstellen, welche durch die in der betreffenden Kontaktzone vorhandenen Leitungsstücke OVAP (vorzugsweise durch die verbreiterten Endabschnitte E derselben) gebildet werden können, in Kontakt; in der nach oben geschobenen Stellung der Stange KET besteht kein Kontakt zwischen den Nadeln KE und dem Wafer.

Dadurch, daß der Wafer über mehrere (im betrachteten Beispiel 4, gegebenenfalls aber auch mehr oder weniger) Kontaktzonen C1 bis C4 verfügt, über welche jeweils allen auf dem Wafer vorgesehenen integrierten Schaltungen IC die zum Testen derselben durch die darin enthaltenen BIST-Module benötigten Spannungen und Signale zugeführt werden können, kann die Zufuhr der Spannungen und Signale auch dann aufrechterhalten werden, wenn der Wafer - aus welchem Grund auch immer - von dem diesen tragenden Träger heruntergenommen werden muß.

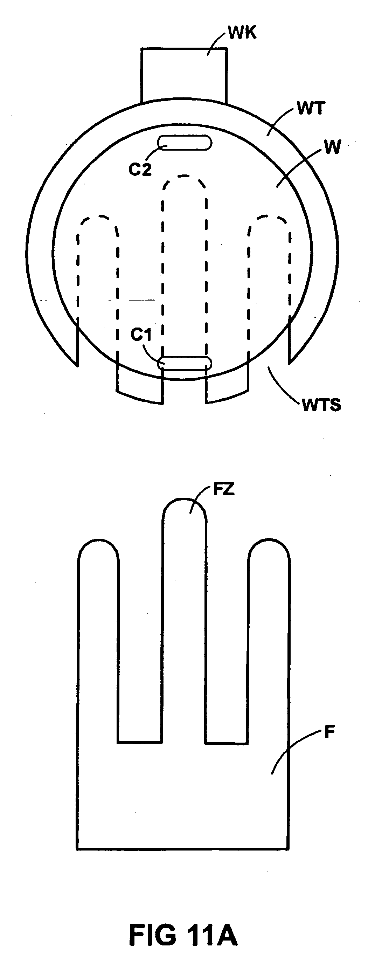

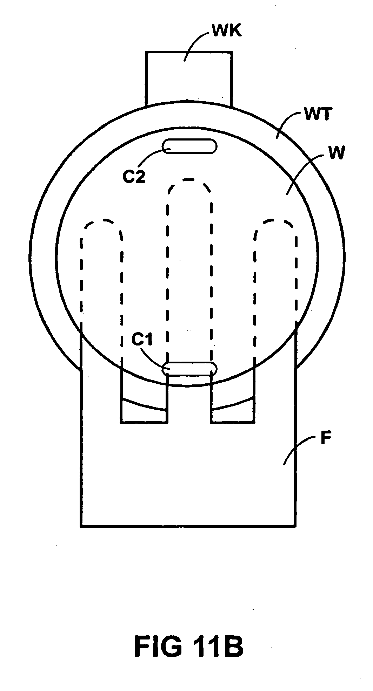

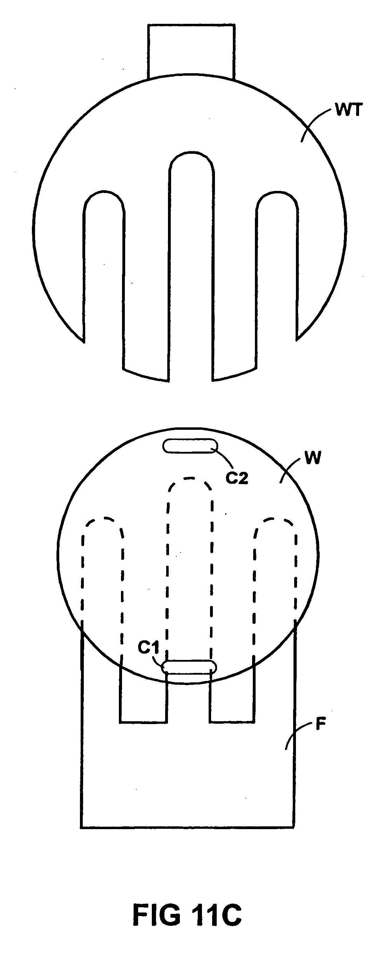

Eine Möglichkeit zum Herunternehmen des Wafers W vom Träger WT unter ununterbrochener Aufrechterhaltung der Zufuhr der genannten Spannungen und Signale zu den integrierten Schaltungen ist schematisch in den Figuren 11A bis 11C veranschaulicht. Die den Wafer W vom Waferträger WT herunternehmende Vorrichtung ist im betrachteten Beispiel eine Gabel F, deren Zinken FZ von der Seite des Trägers WT her in zugeordnete schlitzartige Aussparungen WTS des Trägers WT eingeschoben werden können und den Wafer W unter leichtem Anheben desselben vom Träger WT wegziehen können. Die Figur 11A zeigt den Zustand, in welchem sich der Wafer W noch auf dem Träger WT befindet und über die Kontaktzone C2 die von den integrierten Schaltungen benötigten Spannungen und Signale zugeführt bekommt. In der Figur 11B ist der Zustand gezeigt, in welchem die Gabel F in den Waferträger geschoben ist. In diesem Stadium bekommt der Wafer die von den integrierten Schaltungen benötigten Spannungen und Signale zunächst immer noch über die Kontaktzone C2 zugeführt. Nachdem die Gabel F eine bestimmte Relativlage zum Wafer W (oder dem diesen tragen Träger WT) erreicht hat, werden die in der Kontaktzone C1 des Wafers W vorgesehenen Kontaktstellen durch eine in den Figuren nicht gezeigte, an der Gabel F angeordnete Kontaktiervorrichtung kontaktiert, wodurch die auf dem Wafer vorgesehenen integrierten Schaltungen nun auch über die Kontaktzone C1 mit den von ihnen benötigten Spannungen und Signalen versorgt werden. Nachdem dies geschehen ist, wird die über die Kontaktzone C2 erfolgende Zufuhr der von den integrierten Schaltungen benötigten Spannungen und Signale durch Lösen der entsprechenden elektrischen Verbindungen unterbrochen. Wie bereits angedeutet wurde, hat die Unterbrechung dieser Verbindung nicht zu Folge, daß die integrierten Schaltungen die von ihnen benötigten Spannungen und Signale nicht mehr erhalten; diese wurden und werden ihnen ja auch noch über die Kontaktzone C1 zugeführt. Danach kann der Wafer W durch die Gabel F leicht angehoben und zusammen mit dieser vom Träger WT weggezogen werden; dies ist in Figur 11C dargestellt.

Ein wie beschrieben durchgeführtes Abnehmen des Wafers W vom Waferträger WT erfolgt vorzugsweise zu einem Zeitpunkt, zu welchem der durch das BIST-Modul durchzuführende Test der integrierten Schaltungen bereits beendet ist. Dann muß den integrierten Schaltungen über die Gabel F und die Kontaktzone C1 "nur" noch die Versorgungsspannung VddR zugeführt werden. Dies kann beispielsweise durch eine Batterie oder einen Kondensator erfolgen, die bzw. der in der den Wafer W vom Waferträger WT abnehmenden Vorrichtung vorgesehen ist; bei der Verwendung eines Kondensators könnte vorgesehen werden, diesen während der Zeit, während welcher der Wafer sowohl über die Kontaktzone C1 als auch über die Kontaktzone C2 kontaktiert wird, durch die dem Wafer über die Kontaktzone C2 zugeführte Energie aufzuladen.

Es wäre auch denkbar, dem Wafer die Versorgungsspannungen Vdd und/oder VddR über eine mit dem Wafer fest verbundene Batterie oder einen mit dem Wafer fest verbundenen Kondensator zuzuführen. Dadurch entfällt u.U. die Notwendigkeit, den Wafer bei einer Abnahme desselben vom Waferträger über eine an der Abnahmevorrichtung vorgesehene Kontaktiervorrichtung zu kontaktieren.

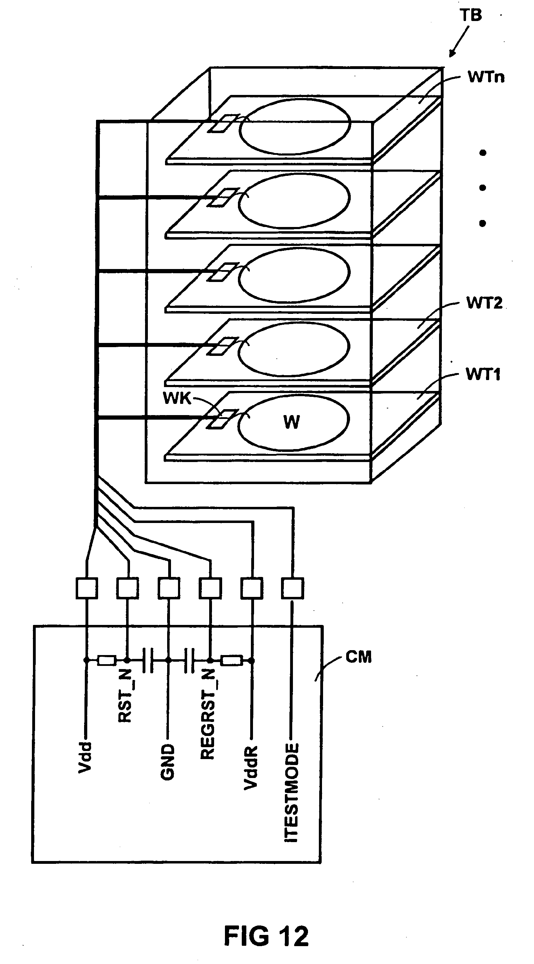

Es kann auch vorgesehen werden, die integrierten Schaltungen mehrerer Wafer gleichzeitig zu testen. Dies ist beispielsweise durch eine in Figur 12 gezeigte Testbox TB möglich. Die gezeigte Testbox TB enthält ein Gehäuse G und mehrere übereinander angeordnete Waferträger WT1 bis WTn, die wie oder ähnlich wie der unter Bezugnahme auf die Figuren 10 und 11 beschriebene Waferträger WT aufgebaut sind. Insbesondere enthält jeder Waferträger eine Kontaktiervorrichtung WK, wobei die Kontaktiervorrichtungen aller Waferträger mit einer die benötigten Spannungen und Signale bereitstellenden bzw. erzeugenden gemeinsamen Steuereinrichtung CM verbunden sind. Die Steuereinrichtung CM wird entweder mit der Testbox mittransportiert, oder ist über so lange Leitungen mit den Kontaktiervorrichtungen WK verbunden, daß die Testbox TB und die Steuereinrichtung CM relativ zueinander bewegbar sind. Das gleichzeitige Testen der auf mehreren Wafern hergestellten integrierten Schaltungen ermöglicht es, die Anzahl der hierfür vorzusehenden Steuereinrichtungen CM auf ein Minimum zu reduzieren.

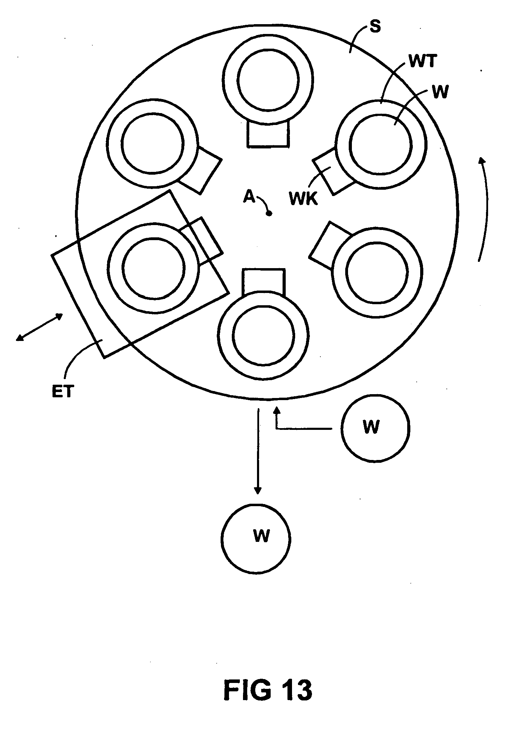

Es dürfte einleuchten, daß das gleichzeitige Testen der integrierten Schaltungen von mehreren Wafern auch anders als durch die vorstehend beschriebene Testbox TB erfolgen kann. Eine Möglichkeit hierfür ist in Figur 13 dargestellt. Bei der in der Figur 13 dargestellten Anordnung sind die Waferträger WT1 ... WTn nebeneinander auf einer um eine Achse A drehbaren Scheibe S angeordnet. Die Waferträger WT1 ... WTn sind wiederum wie oder ähnlich wie der unter Bezugnahme auf die Figuren 10 und 11 beschriebene Waferträger WT aufgebaut. Neben der sich drehenden Scheibe S ist eine externe Testvorrichtung ET angeordnet. Jedes Mal, wenn ein Waferträger WT mit einen darauf befindlichen Wafer W an der externen Testvorrichtung ET vorbeiläuft, wird die Scheibe S angehalten und
- werden die auf dem Wafer W befindlichen integrierten Schaltungen IC getestet,
- wird der Wafer W, dessen integrierte Schaltungen zuvor getestet wurde, von dem diesen tragenden Waferträger WT heruntergenommen, und
- wird auf den Waferträger, von welchem der Wafer heruntergenommen wurde, ein nächster Wafer aufgesetzt, und
- wird sofort oder später damit begonnen, den neu hinzugekommenen Wafer zu testen.

Eine solche Anordnung weist den Vorteil auf, daß die Wafer während des gesamtes Testvorganges der auf dem Wafer vorgesehenen integrierten Schaltungen auf den Waferträgern WT1 bis WTn liegen bleiben können und nicht zwischendurch umgesetzt werden müssen.

Es dürfte einleuchten, daß es sich bei der die Waferträger tragenden Vorrichtung auch um ein Förderband oder eine beliebige andere Transportvorrichtung handeln kann, durch welche die Waferträger mit den darauf angeordneten Wafern zur externen Testvorrichtung befördert werden können.

Das vorstehend beschriebene Verfahren zum Testen von integrierten Schaltungen kann - bei entsprechender Modifikation - auch bei integrierte Schaltungen enthaltenden Halbleiter-Chips und bei Halbleiter-Chips enthaltenden Bauteilen zum Einsatz kommen.

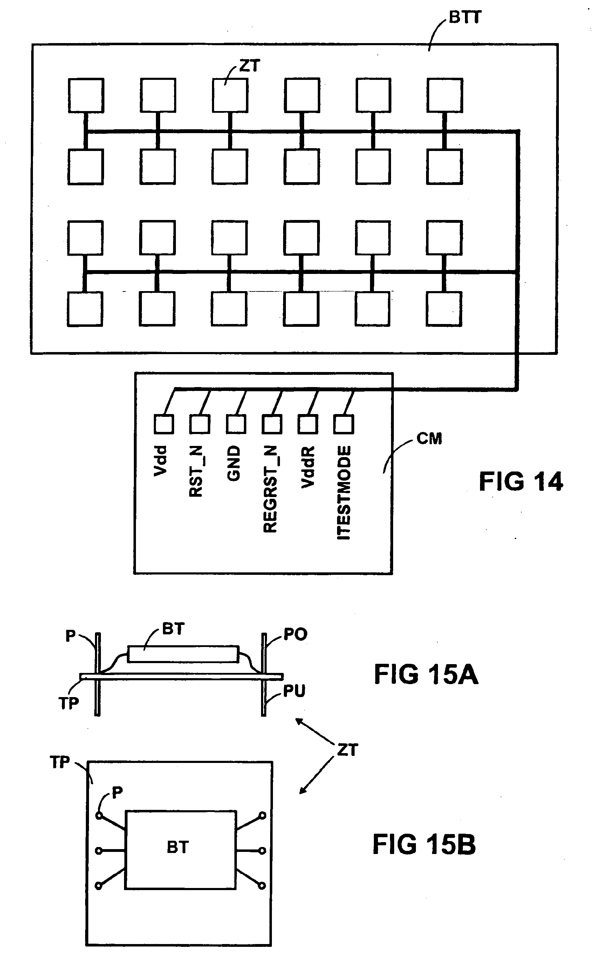

Eine Anordnung, durch welche Halbleiter-Chips enthaltende Bauteile getestet werden können, ist in Figur 14 dargestellt.

Die in der Figur 14 gezeigte Anordnung besteht aus einem eine Vielzahl von zu testenden Bauteilen BT tragenden Bauteilträger BTT und einer Steuereinrichtung CM, welche dafür sorgt, daß zumindest damit begonnen wird, die Bauteile durch die in ihnen (in den integrierten Schaltungen derselben) enthaltenen BIST-Module zu testen, bevor sie (zur Auswertung der Selbsttest-Ergebnisse und/oder zum Weitertesten) mit einer externen Testvorrichtung verbunden werden. Die Steuereinrichtung CM führt den Bauteilen die Spannungen und Signale zu, die zur Einleitung und Durchführung des Testens derselben durch die in Ihnen vorhandenen BIST-Module benötigen, also beispielsweise Vdd, VddR, GND, RST_N, RSTREG_N, und ITESTMODE. Die Bauteile werden zumindest teilweise parallel angesteuert, wodurch jeweils mehrere oder alle der auf dem Bauteilträger BTT vorhandenen Bauteile BT gleichzeitig durch die in ihnen enthaltenen BIST-Module getestet werden.

Die Anordnung der Bauteile BT auf dem Bauteilträger BTT erfolgt vorzugsweise über die Bauteile tragende und auf den Bauteilträger BTT aufsetzbare Zwischenträger, welche (zusammen mit den Bauteilen) so vom Bauteilträger abgenommen werden können, daß die Zufuhr der Spannungen und Signale, die den Bauteilen zum betreffenden Zeitpunkt zugeführt werden müssen, nicht unterbrochen wird. Ein Ausführungsbeispiel eines solchen Zwischenträgers ist in den Figuren 15A und 15B gezeigt. Der in den Figuren 15A und 15B gezeigte, mit dem Bezugszeichen ZT bezeichnete Zwischenträger ist eine Trägerplatte TP mit diese durchlaufenden Stiften P. Das Bauteil BT wird so auf den Zwischenträger ZT aufgesetzt und befestigt, daß die Bauteil-Anschlüsse, die zum Testen des Bauteils durch das BIST-Modul und die externe Testvorrichtung benötigt werden, mit jeweils zugeordneten Stiften elektrisch verbunden werden. Einem auf einen solchen Zwischenträger aufgesetzten Bauteil können die Spannungen und Signale, die ihm zum Testen durch das BIST-Modul zugeführt werden müssen, wahlweise über die unterhalb der Trägerplatte TP verlaufenden Stift-Teile PU oder über die oberhalb der Trägerplatte TP verlaufenden Stift-Teile PO zugeführt werden, wobei die Zuführung über die unteren Stift-Teile PU erfolgt, wenn und so lange der Zwischenträger ZT auf der Trägerplatte TP aufgesetzt ist, und wobei die Zuführung über die oberen Stift-Teile PO erfolgt, wenn der Zwischenträger ZT von der Trägerplatte TP abgenommen wird (beispielsweise um an die den Bauteil-Test fortsetzende externe Testvorrichtung angeschlossen zu werden).

Auf ähnliche Art und Weise lassen sich auch Halbleiter-Chips testen.

Die beschriebenen Verfahren und Vorrichtungen ermöglichen es unabhängig von den Einzelheiten der praktischen Realisierung, integrierte Schaltungen schnell und einfach zu testen.

### Bezugszeichenliste

- A: Drehachse von S
- ANDx: UND-Glieder
- BIST: Build-In-Self-Test-Modul in IC
- C: Taktanschluß von DREG
- CLK: Taktsignal
- CLKGEN: interner Taktsignalgenerator in IC
- CLKOFF: Steuersignal in IC
- CM: Steuereinrichtung
- DREGx: Register Von REGB
- D: Dateneingabeanschluß von DREG
- D2-D5: das Testergebnis des Selbsttests repräsentierende Daten
- E: verbreiterter Endabschnitt von OVAP
- ET: externe Testvorrichtung
- EXTCLK: externes Taktsignal für IC
- F: Gabel
- FV: Führungsvorrichtung für KET
- FZ: Zinken von F
- G: Gehäuse von TB
- IC: integrierte Schaltung
- IN: Eingangsanschluß von IPCT
- INV: Inverter
- IPCT: Schnittstellenschaltung in IC
- ITESTMODE: Steuersignal für IC
- K: Knotenpunkt in IPCT
- KE: Kontakt-Nadeln von WK
- KET: Stange von WK
- Nx: NMOS-Transistoren
- OUT: Ausgangssignal von IPCT
- OVA: Verbindungen zwischen ICs
- OVAC: die OVAs eines IC verbindenden Leitungen
- OVAPx: Leitungsstücke zur Herstellung der OVAs
- Q: Datenausgabeanschluß von DREG
- P: Stifte von TP
- Px: PMOS-Transistoren
- PO: oberer Teil von P
- PU: unterer Teil von P
- Q2-Q5: das Testergebnis des Selbsttests repräsentierende Daten
- R: Rücksetzanschluß von DREG
- READY: Steuersignal in IC
- REGB: Testergebnis-Speicher in IC
- REGRST_N: Steuersignal für IC
- ROC: Rest von IC
- RST-C: Kondensator
- RST_N: Steuersignal für IC
- RST-R: Widerstand
- S: Scheibe
- ST: Schmitt-Trigger
- STROBE: Steuersignal in IC
- T: Transistor
- TP: Trägerplatte
- TB: Testbox
- Vdd: erste Versorgungsspannung für IC
- VddR: zweite Versorgungsspannung für IC
- W: Wafer
- WK: Wafer-Kontaktiervorrichtung
- WTx: Waferträger
- WTS: Aussparungen in WT
- ZT: Zwischenträger

## Patentansprüche

1. Verfahren zum Testen einer integrierten Schaltung unter Verwendung einer in dieser enthaltenen Selbsttestvorrichtung,
**dadurch gekennzeichnet,**
**daß** das Testen der integrierten Schaltung (IC) durch die Selbsttestvorrichtung (BIST) während des Transports der integrierten Schaltung zu einer die Ergebnisse des Selbsttests auslesenden und/oder auswertenden und weitere Tests durchführenden externen Testvorrichtung (ET) erfolgt, und daß das Testen der integrierten Schaltung (IC) durch die Selbsttestvorrichtung (BIST) begonnen wird, bevor die integrierte Schaltung an die externe Testvorrichtung (ET) angeschlossen wird.

2. Verfahren nach Anspruch 1,
**dadurch gekennzeichnet,**
**daß** das Testen der integrierten Schaltung (IC) durch die Selbsttestvorrichtung (BIST) so frühzeitig begonnen wird, daß der Selbsttest abgeschlossen ist, bevor die integrierte Schaltung an die die Ergebnisse des Selbsttests auslesende und/oder auswertende externe Testvorrichtung (ET) angeschlossen wird.

3. Verfahren nach einem der vorhergehenden Ansprüche,
**dadurch gekennzeichnet,**
**daß** eine das Testen der integrierten Schaltung (IC) durch die Selbsttestvorrichtung (BIST) veranlassende Selbsttest-Steuervorrichtung (CM) mit der zu testenden integrierten Schaltung mitbewegt wird.

4. Verfahren nach einem der vorhergehenden Ansprüche,
**dadurch gekennzeichnet,**
**daß** zumindest Teile der integrierten Schaltung (IC) während des Testens und/oder nach dem Testen derselben durch die Selbsttestvorrichtung (BIST) außer Betrieb gesetzt werden.

5. Verfahren nach Anspruch 4,
**dadurch gekennzeichnet,**
**daß** nach dem Testen der integrierten Schaltung (IC) durch die Selbsttestvorrichtung (BIST) die Komponenten der integrierten Schaltung, die nicht dazu benötigt werden, um in einem von der Selbsttestvorrichtung beschriebenen Testergebnis-Speicher (REGB) gespeicherte Daten weiter zu speichern, außer Betrieb gesetzt werden.

6. Verfahren nach Anspruch 4 oder 5,
**dadurch gekennzeichnet,**
**daß** das Außerbetriebsetzen der integrierten Schaltung (IC) ein Unterbinden der Zufuhr eines zum Betrieb der integrierten Schaltung erforderlichen Taktsignals (CLK) zu einzelnen, mehreren oder allen Komponenten der integrierten Schaltung umfaßt.

7. Verfahren nach einem der Ansprüche 4 bis 6,
**dadurch gekennzeichnet,**
**daß** das Außerbetriebsetzen der integrierten Schaltung (IC) ein Unterbinden der Zufuhr einer die integrierte Schaltung mit Energie versorgenden Versorgungsspannung (Vdd) zu einzelnen oder mehreren Komponenten der integrierten Schaltung umfaßt.

8. Verfahren nach einem der vorhergehenden Ansprüche,
**dadurch gekennzeichnet,**
**daß** das Testen der integrierten Schaltung (IC) durch die Selbsttestvorrichtung (BIST) gleichzeitig für eine Vielzahl von integrierten Schaltungen durchgeführt wird.

9. Verfahren nach Anspruch 8,
**dadurch gekennzeichnet,**
**daß** das Testen der integrierten Schaltung (IC) durch die Selbsttestvorrichtung (BIST) gleichzeitig für alle integrierten Schaltungen eines oder mehrerer Wafer (W) durchgeführt wird.

10. Verfahren nach einem der vorhergehenden Ansprüche,
**dadurch gekennzeichnet,**
**daß** die integrierte Schaltung (IC) Mittel enthält, durch welche veranlaßbar ist, daß der Inhalt eines von der Selbsttestvorrichtung (BIST) beschriebenen Testergebnis-Speichers (REGB) nach dem Testen der integrierten Schaltung durch die Selbsttestvorrichtung nicht mehr verändert werden kann.

11. Verfahren nach einem der Ansprüche 10,
**dadurch gekennzeichnet,**
**daß** die integrierte Schaltung (IC) Mittel enthält, durch welche anhand der in einem von der Selbsttestvorrichtung (BIST) beschriebenen Testergebnis-Speicher (REGB) gespeicherten Daten erkennbar ist, ob der von der Selbsttestvorrichtung durchzuführende Test beendet ist oder nicht.

12. Verfahren nach Anspruch 10 oder 11,
**dadurch gekennzeichnet,**
**daß** die integrierte Schaltung (IC) so ausgebildet ist, daß ihr die Spannungen und Signale, die ihr zugeführt werden müssen, damit sie durch die in ihr enthaltene Selbsttestvorrichtung (BIST) getestet wird, jeweils über mindestens zwei verschiedene Stellen (C1 bis C4) zuführbar sind.

13. Verfahren nach Anspruch 12,
**dadurch gekennzeichnet,**
**daß** die mindestens zwei verschiedenen Stellen (C1 bis C4) elektrisch miteinander verbunden sind.

14. Verfahren nach einem der vorhergehenden Ansprüche,
**dadurch gekennzeichnet,**
**daß** die integrierte Schaltung Bestandteil eines Wafers mit einer Vielzahl von integrierten Schaltungen ist, und daß später durch ein Zerschneiden des Wafers (W) zu vereinzelnde integrierte Schaltungen (IC) zumindest teilweise elektrisch miteinander verbunden sind.

15. Verfahren nach Anspruch 14,
**dadurch gekennzeichnet,**
**daß** die die integrierten Schaltungen (IC) verbindenden elektrischen Verbindungen (OVA) durch auf dem Wafer (W) ausgebildete Leiterbahnen (OVAP) gebildet werden.

16. Verfahren nach Anspruch 14 oder 15,
**dadurch gekennzeichnet,**
**daß** die die integrierten Schaltungen (IC) verbindenden elektrischen Verbindungen (OVA) jeweils diejenigen Stellen der integrierten Schaltungen miteinander verbinden, welchen zum Testen der integrierten Schaltungen durch eine in ihnen enthaltene Selbsttestvorrichtung (BIST) bestimmte Spannungen und/oder Signale zugeführt werden müssen.

17. Verfahren nach einem der Ansprüche 14 bis 16,
**dadurch gekennzeichnet,**
**daß** der Wafer (W) Kontaktzonen (C1 bis C4) enthält, die so angeordnet und ausgebildet sind, daß daran angelegte Spannungen und Signale über die die integrierten Schaltungen (IC) miteinander verbindenden elektrischen Verbindungen (OVA) an mehrere oder alle integrierte Schaltungen des Wafers weiterleitbar sind.

## Claims

1. Method of testing an integrated circuit, using a self-test device contained in the latter, **characterized in that** the testing of the integrated circuit (IC) by the self-test device (BIST) is carried out during the transport of the integrated circuit to an external testing device (ET) that reads out and/or evaluates the results of the self test and carries out further tests, and **in that** the testing of the integrated circuit (IC) by the self-test device (BIST) is begun before the integrated circuit is connected to an external testing device (ET).

2. Method according to Claim 1, **characterized in that** the testing of the integrated circuit (IC) by the self-test device (BIST) is begun in such good time that the self test has been concluded before the integrated circuit is connected to the external testing device (ET) that reads out and/or evaluates the results of the self test

3. Method according to one of the preceeding Claims, **characterized in that** a self-test control device (CM) that causes the testing of the integrated circuit (IC) by the self-test device (BIST) is moved together with the integrated circuit to be tested.

4. Method according to one of the preceding claims, **characterized in that** at least parts of the integrated circuit (IC) are taken out of operation during testing and/or after the same have been tested by the self-test device (BIST).

5. Method according to Claim 4, **characterized in that**, after the testing of the integrated circuit (IC) by the self-test device (BIST), the components of the integrated circuit which are not needed in order to continue to store data stored in a test result memory (REGB) written by the self-test device are taken out of operation.

6. Method according to Claim 4 or 5, **characterized in that** the action of taking the integrated circuit (IC) out of operation comprises preventing the supply of a clock signal (CLK) needed to operate the integrated circuit to individual, a plurality of or all the components of the integrated circuit.

7. Method according to one of Claims 4 to 6, **characterized in that** the action of taking the integrated circuit (IC) out of operation comprises preventing the supply of a supply voltage (Vdd) that supplies the integrated circuit with power to individual or a plurality of components of the integrated circuit.

8. Method according to one of the preceding claims, **characterized in that** the testing of the integrated circuit (IC) by the self-test device (BIST) is carried out simultaneously for a large number of integrated circuits.

9. Method according to Claim 8, **characterized in that** the testing of the integrated circuit (IC) by the self-test device (BIST) is carried out simultaneously for all the integrated circuits of one or more wafers (W).

10. Method according to one of the preceding claims, **characterized in that** the integrated circuit (IC) contains means which make it possible to arrange that the content of a test result memory (REGB) that is written by the self-test device (BIST) can no longer be changed after the testing of the integrated circuit by the self-test device.

11. Method according to one of Claims 10, **characterized in that** the integrated circuit (IC) contains means which make it possible, by using data stored in a test result memory (REGB) that is written by the self-test device (BIST), to detect whether the test to be carried out by the self-test device has been completed or not.

12. Method according to Claim 10 or 11, **characterized in that** the integrated circuit (IC) is constructed in such a way that the voltages and signals which have to be supplied to it in order that it can be tested by the self-test device (BIST) contained in it can in each case be supplied to it via at least two different points (C1 to C4).

13. Method according to Claim 12, **characterized in that** the at least two different points (C1 to C4) are connected to one another electrically.

14. Method according to one of the preceding claims, **characterized in that** the integrated circuit is an integral part of a wafer with a large number of integrated circuits, **characterized in that** integrated circuits (IC) to be separated later by cutting up the wafer (W) are at least partially electrically connected to one another.

15. Method according to Claim 14, **characterized in that** the electrical connections (OVA) that connect the integrated circuits (IC) are formed by conductor tracks (OVAP) formed on the wafer (W).

16. Method according to Claim 14 or 15, **characterized in that** the electrical connections (OVA) that connect the integrated circuits (IC) in each case connect together those points on the integrated circuits to which specific voltages and/or signals must be supplied in order to test the integrated circuits by means of a self-test device (BIST) contained in them.

17. Method according to one of Claims 14 to 16, **characterized in that** the wafer (W) contains contact zones (C1 to C4) which are arranged and constructed in such a way that voltages and signals applied to them can be led onward, via the electrical connections (OVA) that connect the integrated circuits (IC) to one another, to a plurality of or all the integrated circuits on the wafer.

## Revendications

1. Procédé pour tester un circuit intégré en utilisant un dispositif d'autotest contenu dans celui-ci, **caractérisé en ce que** le test du circuit intégré (IC) par le dispositif d'autotest (BIST) est effectué pendant le transport du circuit intégré vers un dispositif de test externe (ET) qui lit et/ou interprète les résultats de l'autotest et qui exécute d'autres tests, et que le test du circuit intégré (IC) par le dispositif d'autotest (BIST) commence avant que le circuit intégré soit connecté au dispositif de test externe (ET).

2. Procédé selon la revendication 1, **caractérisé en ce que** le test du circuit intégré (IC) par le dispositif d'autotest (BIST) commence suffisamment tôt pour que l'autotest soit terminé avant que le circuit intégré soit connecté au dispositif de test externe (ET) qui lit et/ou interprète les résultats de l'autotest.

3. Procédé selon l'une des revendications précédentes, **caractérisé en ce qu'**un dispositif de commande d'autotest (CM) qui initie le test du circuit intégré (IC) par le dispositif d'autotest (BIST) est déplacé conjointement avec le circuit intégré à tester.

4. Procédé selon l'une des revendications précédentes, **caractérisé en ce qu'**au moins des parties du circuit intégré (IC) sont mises hors service pendant le test et/ou après le test de celui-ci par le dispositif d'autotest (BIST).

5. Procédé selon la revendication 4, **caractérisé en ce qu'**après le test du circuit intégré (IC) par le dispositif d'autotest (BIST), les composants du circuit intégré qui ne sont pas nécessaires pour réenregistrer les données enregistrées dans une mémoire de résultat de test (REGB) écrite par le dispositif d'autotest sont mis hors service.

6. Procédé selon la revendication 4 ou 5, **caractérisé en ce que** la mise hors service du circuit intégré (IC) inclut l'inhibition de l'acheminement d'un signal d'horloge (CLK) nécessaire au fonctionnement du circuit intégré vers des composants individuels, plusieurs composants ou la totalité des composants du circuit intégré.

7. Procédé selon l'une des revendications 4 à 6, **caractérisé en ce que** la mise hors service du circuit intégré (IC) inclut l'inhibition de l'acheminement d'une tension d'alimentation (Vdd) qui approvisionne le circuit intégré en énergie vers des composants individuels ou plusieurs composants du circuit intégré.

8. Procédé selon l'une des revendications précédentes, **caractérisé en ce que** le test du circuit intégré (IC) par le dispositif d'autotest (BIST) est effectué simultanément pour une pluralité de circuits intégrés.

9. Procédé selon la revendication 8, **caractérisé en ce que** le test du circuit intégré (IC) par le dispositif d'autotest (BIST) est effectué simultanément pour tous les circuits intégrés d'une ou de plusieurs galettes (W).

10. Procédé selon l'une des revendications précédentes, **caractérisé en ce que** le circuit intégré (IC) contient des moyens qui permettent d'empêcher que le contenu d'une mémoire de résultat de test (REGB) écrite par le dispositif d'autotest (BIST) puisse être modifié par le dispositif d'autotest après le test du circuit intégré.

11. Procédé selon la revendication 10, **caractérisé en ce que** le circuit intégré (IC) contient des moyens qui permettent de reconnaître, au moyen des données enregistrées dans une mémoire de résultat de test (REGB) écrite par le dispositif d'autotest (BIST), si le test effectué par le dispositif d'autotest est terminé ou non.

12. Procédé selon la revendication 10 ou 11, **caractérisé en ce que** le circuit intégré (IC) est configuré de telle sorte que les tensions et les signaux qui doivent lui être acheminés afin qu'il puisse être testé par le dispositif d'autotest (BIST) qu'il contient puissent respectivement lui être acheminés par au moins deux endroits différents (C1 à C4).

13. Procédé selon la revendication 12, **caractérisé en ce que** les au moins deux endroits différents (C1 à C4) sont reliés électriquement entre eux.

14. Procédé selon l'une des revendications précédentes, **caractérisé en ce que** le circuit intégré fait partie d'une galette comprenant une pluralité de circuits intégrés et que des circuits intégrés (IC) à séparer ultérieurement par une découpe de la galette (W) sont au moins en partie reliés électriquement entre eux.

15. Procédé selon la revendication 14, **caractérisé en ce que** les liaisons électriques (OVA) qui relient les circuits intégrés (IC) sont constituées par des pistes conductrices (OVAP) formées sur la galette (W).

16. Procédé selon la revendication 14 ou 15, **caractérisé en ce que** les liaisons électriques (OVA) qui relient les circuits intégrés (IC) relient respectivement entre eux les endroits des circuits intégrés auxquels il faut acheminer certaines tensions et/ou certains signaux en vue du test des circuits intégrés par un dispositif d'autotest (BIST) qui y est inclus.

17. Procédé selon l'une des revendications 14 à 16, **caractérisé en ce que** la galette (W) contient des zones de contact (C1 à C4) qui sont disposées et configurées de telle sorte que les tensions et les signaux qui y sont appliqués peuvent être retransmis à plusieurs ou à la totalité des circuits intégrés de la galette par le biais des liaisons électriques (OVA) qui relient les circuits intégrés (IC) entre eux.
